# EUROPEAN PATENT SPECIFICATION

(11) **EP 4 293 864 B1**
(45) Date of publication and mention of the grant of the patent: **09.12.2026**
(21) Application number: 23175108.2
(22) Date of filing: 24.05.2023
(51) Int. Cl.: H02J 7/62, H02J 7/96

(54) **CAPACITOR CHARGING CIRCUIT AND DEVICE INCLUDING THE SAME**
KAPAZITOR-LADESCHALTUNG UND VORRICHTUNG, DIE DIESE UMFASST
CIRCUIT DE CHARGE DE CONDENSATEUR ET DISPOSITIF COMPRENANT CELUI-CI

(30) Priority: 14.06.2022 IT 202200012617
(43) Date of publication of application: 20.12.2023
(73) Proprietor: STMicroelectronics S.r.l., 20864 Agrate Brianza (MB) (IT)
(72) Inventor: MARZO, Alberto, I-95014 Giarre (Catania) (IT); RANDAZZO, Vincenzo, I-95033 Biancavilla (Catania) (IT); POLETTO, Vanni, I-20151 Milano (IT); SUSINNA, Giovanni, I-95123 Catania (IT)
(74) Representative: Buzzi, Notaro & Antonielli d'Oulx S.p.A.

(56) References cited:
- NL-C2- 1 029 133
- US-A1- 2017 220 058
- US-A1- 2018 013 294
- US-A1- 2021 288 486

## Description

### Technical field

The description relates to capacitor (pre)charging.

One or more embodiments can be applied, for instance, in an electronic fuse (e-fuse or eFuse) for use in the automotive sector.

### Background

In a current circuit topology for electronic fuses (hereinafter, eFuses) power elements are connected to a power source such as a battery to supply one or more electrical loads; eFuses are designed and sized to drive loads with a certain nominal current and to switch off power elements in case of the current exceeds the nominal value.

The load may have, connected in parallel, a large capacitor, in the range of a few mF to tens of mF. It is desired that, at startup, the eFuse should be able to charge this large capacitor before a nominal current is started to be provided to the load.

This desired mode of operation involves two problems:
the capacitive load should desirably be charged in a relatively short time frame, e.g., about 50 to about 200ms;
when the output voltage is zero, the capacitor behaves like a short circuit: if the eFuse switches power elements in a fully "on" mode, a large current will flow and it becomes difficult for the eFuse to discriminate between a high current due to normal charging of a large capacitive load and an actual short-circuit condition.

It is thus desirable that the charging process of the capacitive load should follow a desired strategy.

Document US 2018/013294 A1 discloses a circuit for controlling at least two electronic switches in a parallel configuration between a power supply and a load. The circuit includes a control circuit to generate first and second control signals to control first and second electronic switches of the at least two electronic switches, and establish a conduction sequence of the first and second electronic switches using the first and second control signals. The circuit includes a detection circuit configured to detect a current flowing through a control terminal of the first electronic switch during a transition portion, wherein the circuit is configured to adjust the first control signal and establish the second portion of the conduction sequence in response to the detected current.

In the solution disclosed in document US 2017/220058 A1 a significant reduction of the amplitude of the transient response is obtained by keeping a low dropout regulator circuit in a closed loop condition. This is achieved by manipulation of the reference voltage level when an open loop condition arises due to a falling input voltage. The reference voltage level is tracked with the input voltage level, keeping the output voltage regulated. As a consequence, the power pass element of the regulator is not forced into the linear region (in the case of a MOSFET) or deep saturation (in the case of a bipolar transistor).

Also documents NL 1 029 133 C2 and US 2021/288486 A1 are of interest for the invention.

### Object and summary

An object of one or more embodiments is to contribute in providing improved solutions to address the issues discussed in the foregoing.

Such an object can be achieved via a circuit having the features set forth in the independent claim 1.

One or more embodiments may relate to a corresponding device. Devices for use, e.g., in the automotive sector and including one or more eFuses may be exemplary of such a device.

The claims are an integral part of the technical disclosure provided herein in connection with the embodiments.

Solutions presented herein by way of example relate to load capacitor pre-charging for eFuse applications wherein an undesirably high "inrush" current is avoided.

Solutions presented herein by way of example can be applied in a high-side configuration wherein a current through an electronic switch (a MOSFET transistor, for instance) and a load is controlled as a function of the gate-source voltage of the MOSFET transistor and an associated threshold value.

In solutions presented herein, the current is controlled setting a gate-source voltage until the MOSFET transistor enters the fully "on" region, thus avoiding an undesirably high inrush current.

In solutions presented herein, a capacitance coupled to a source of electrical charge (a battery, for instance) via a drain-source current flow path through a field-effect transistor, is (pre)charged by making the field-effect transistor selectively conductive in response to the gate-source voltage of the field-effect transistor exceeding an (e.g., temperature-dependent) threshold. The difference between the gate-source voltage of the field-effect transistor and the threshold provides an overdrive value of the field-effect transistor.

In solutions presented herein, the gate of the field-effect transistor is driven with a variable gate-source voltage by targeting (that is, having as a target) maintaining a constant overdrive value. Electrical charge is thus controllably transferred from the source to the capacitance via the drain-source current flow path through the field-effect transistor.

### Brief description of the several views of the drawings

One or more embodiments will now be described, by way of example only, with reference to the annexed figures, wherein:
Figure 1 is a circuit diagram of a conventional electronic fuse (eFuse);
Figure 2 is illustrative of certain phenomena that affect operation of a field-effect transistor (FET);
Figure 3 presents various possible FET current/voltage characteristics;
Figure 4 is a circuit diagram of an eFuse circuit according to a first possible implementation of an eFuse according to the present description;
Figure 4A is a circuit diagram illustrative of possible details of the eFuse circuit of Figure 4;
Figures 5 and 6 present various diagrams illustrative of possible operation of the eFuse circuit of Figure 4;
Figure 7 is a circuit diagram of an eFuse circuit according to a second possible implementation of an eFuse according to the present description; and
Figures 8 and 9 are circuit diagrams illustrative of possible details of the eFuse circuit of Figure 7.

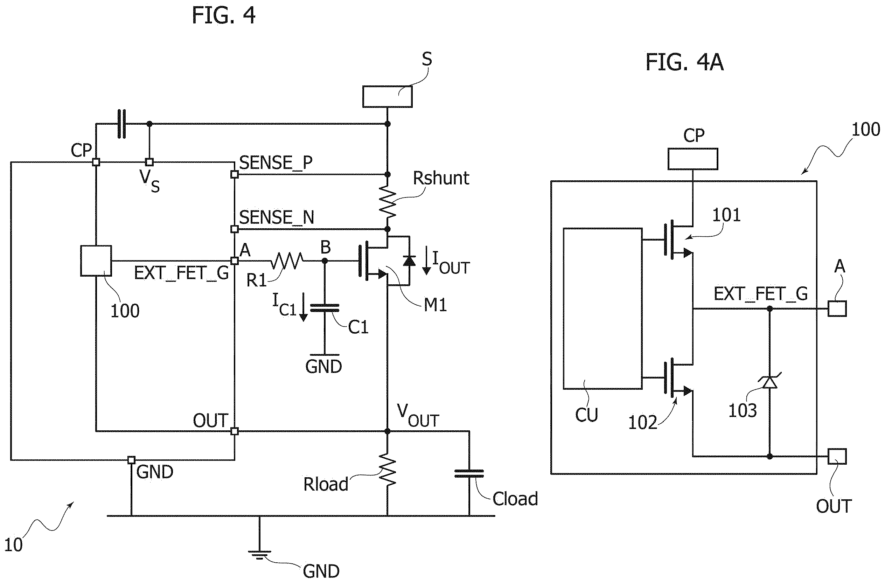

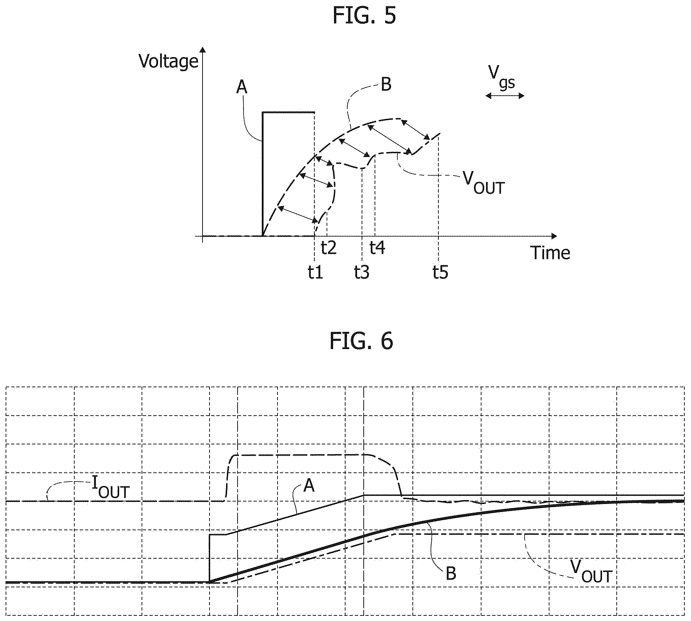

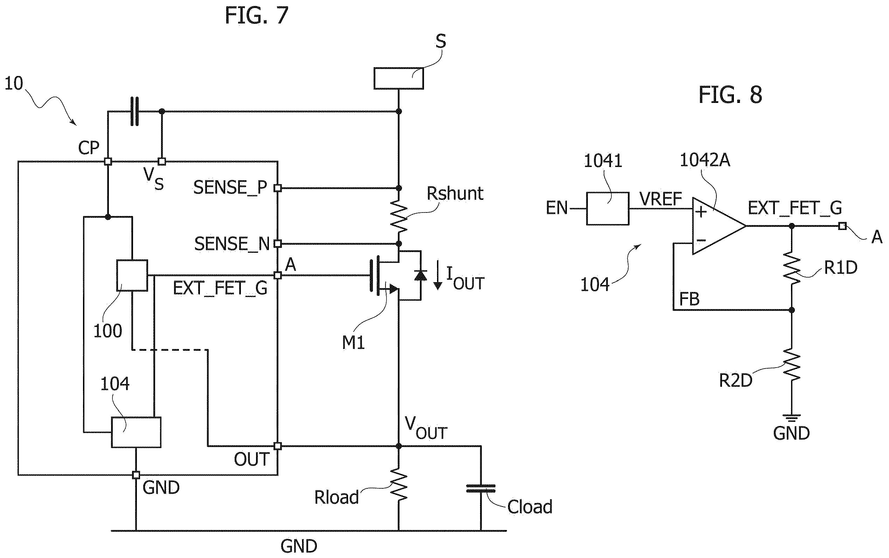

The implementation of Figures 7 to 9 is according to the invention as claimed. The implementation of Figures 4, 4A (operating as shown in Figures 5 and 6) is not per se according to the invention as claimed but is nonetheless useful in understanding the invention.

The figures are drawn to clearly illustrate the relevant aspects of the embodiments and are not necessarily drawn to scale.

Corresponding numerals and symbols in the different figures generally refer to corresponding parts unless otherwise indicated.

The edges of features drawn in the figures do not necessarily indicate the termination of the extent of the feature.

Also, throughout this description, a same designation may be used for brevity to designate:
both a certain node or line and a signal occurring at that node or line, and
both a certain component (e.g., a capacitor or a resistor) and an electrical parameter thereof (e.g., capacitance or resistance/impedance).

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular conformations, structures, or characteristics may be combined in any adequate way in one or more embodiments.

The headings/references used herein are provided merely for convenience and hence do not define the extent of protection or the scope of the embodiments.

Also, throughout the figures, like parts or elements are indicated with like reference symbols, and a corresponding description will not be repeated for each and every figure for brevity.

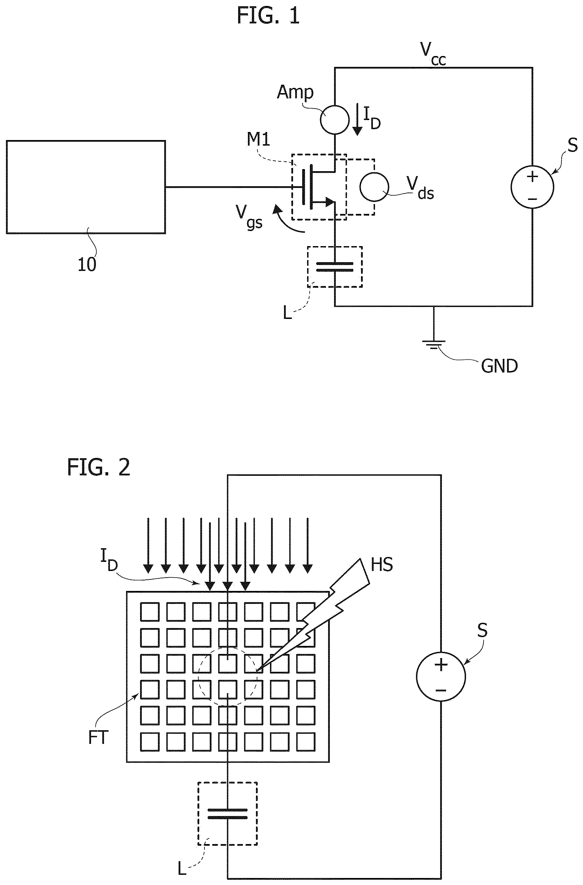

In a conventional arrangement as exemplified in Figure 1, an eFuse device 10 is configured to control an external switch (a field-effect transistor such as a MOSFET transistor M1, for instance).

The switch M1 is configured to couple an electrical load L to a supply source such as a battery S at a voltage V_{CC}. The electrical load L may have a high capacitive value and is represented simply as a capacitor.

In the diagram of Figure 1, the reference Amp indicates a current sense element (this can be a shunt resistor, namely Rshunt, as conventional in the art) that senses the intensity of the current I_{D} through the load L and the switch (MOSFET transistor) M1.

In the diagram of Figure 1, Vgs and Vds indicate the gate-source voltage and the drain-source voltage of the MOSFET transistor M1.

The eFuse device (hereinafter, eFuse) 10 is configured to monitor (via a current sensor Amp) the intensity of the current I_{D} flowing through the load L. The eFuse 10 is configured to switch off the MOSFET transistor M1 based on the level of the current flowing through Rshunt.

At startup one may assume that the load voltage is at ground level: the external switch (MOSFET transistor) M1 has never been switched on before and there is no current flowing from the battery S (voltage V_{CC}) to and through the load L.

As noted, even if the load L can be per se a resistive or dynamic load, it may be assumed to include a large capacitive component (5-10 mF, for instance).

When the external switch (MOSFET transistor M1) is turned on - that is, made conductive - for the first time, the current I_{D} will be determined by the saturation of the external MOSFET transistor M1, and it will have a (very) high intensity value.

In fact, at startup Vds - e.g., with the drain of the external MOSFET M1 at battery level (V_{CC}) and the source of the external MOS at ground level - the MOSFET M1 will be in the saturation region. As a result, considering the transfer characteristic curve of a power MOSFET, with a maximum Vgs the current I_{D} will be substantially at its maximum intensity level.

The eFuse 10 will sense this high current (via the current sensor Amp, e.g., via a shunt resistor Rshunt) and automatically activate protection in response to the current I_{D} sensed being found to be higher than the intervention threshold ("hard-short" current) set for the eFuse: the eFuse will thus switch off the external MOSFET M1.

An attempt to overcome these drawbacks may involve somehow managing the charging of the load L by exploiting the saturation of the MOSFET transistor M1 and controlling the gate-source voltage Vgs. For instance, one may "move" along the transfer characteristic curves of the MOSFET transistor M1 by setting the gate-source voltage Vgs: the lower the Vgs, the lower the drain current I_{D}.

Controlling the voltage Vgs of the MOSFET transistor M1 facilitates pre-charging the load L using a controlled drain current I_{D}, without activating the eFuse protections (hard short protection).

In general terms, that strategy suffers from the fact that MOSFET transistors with (very) low "on" resistance Ron and high transconductance gm (as desired for eFuse applications) are affected by thermal instability ("hot spotting").

Controlling saturation of a MOSFET transistor having a low Ron value may in fact suffer from an inherent drawback related to the specific internal structure of a MOSFET transistor.

As illustrated in Figure 2, a FET transistor FT composed of a plurality of MOSFET cells can be used in order to obtain a low Ron value.

The cells are arranged electrically in parallel and the current I_{D} flows through each of these cells. Each cell has a high value for Ron: however, as a result of the cells being arranged in parallel, the global Ron of the MOSFET transistor is (much) lower than the Ron of each MOSFET cell.

During operation at a high current, the FET transistor generates heat that is dissipated flowing to the surrounding area. As a result, the temperature of the FET dissipating area becomes inevitably higher than the external temperature, with a max peak temperature in a central "hot spot" HS of the FET itself.

The continuing trend to reducing the geometrical dimensions of such FETs leads to concentrating heat dissipation in a smaller area, which makes the "hot spot" problem even more severe.

It is noted that the drain current of a MOSFET transistor starts flowing when the gate-source voltage Vgs becomes higher than a threshold Vth, namely when the overdrive (Vgs-Vth) takes a positive value. The higher the overdrive, the higher the intensity of the current flowing through the open channel of the MOSFET transistor.

It is likewise noted that the threshold Vth decreases as temperature increases. Therefore, since the central area of a transistor as illustrated in Figure 2 has a higher temperature than the peripheral areas, the central area will have a lower value for Vth in comparison with the rest of the transistor structure.

Assuming the gate-source voltage Vgs is maintained constant, the overdrive of the central area will bring more current to the central area. In that way, a loop is created: more current is brought to the central area and a higher power dissipation will occur in that area, causing this area to further warm up with Vth lowered, with even more current flowing through the central area. The structure may thus burn creating a short circuit.

This thermal instability becomes even more critical in eFuse applications.

In fact, a MOSFET transistor for eFuse applications may have:
a low Ron, which can be related to a high density of cells in the MOSFET structure (see Figure 2); and
a high transconductance gm, that is a high current density through the MOSFET transistor and a high current handling capability at a low gate-source voltage: gm = 2(I_{D}/Vov), where Vov denotes the overdrive voltage.

A low Ron and high gm lead to an increase the zero-temperature coefficient of the MOSFET transistor, currently referred to as zero "tempco", ZTC.

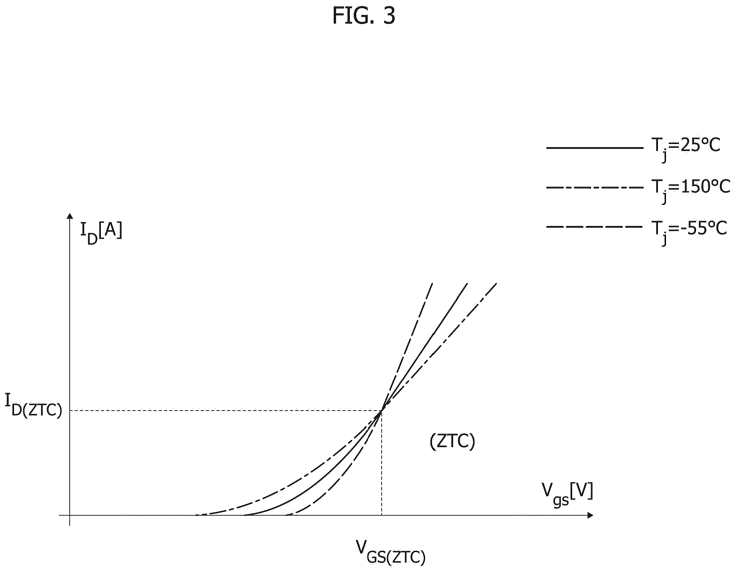

As illustrated in Figure 3, the ZTC point lies at the intersection of the transfer characteristics I_{D} v. Vgs at different junction temperatures Tj (e.g., Tj = 25°C, - 55°C or 150 °C). The ZTC point is the gate-source voltage for which the device current remains stable.

For Vgs > Vgs_{ZTC}, when the device temperature rises, the drain current tends to decrease, leading to a thermal stability condition.

For V_gs < Vgs_{ZTC}, when the device temperature rises the drain current tends to increase leading to a thermal instability condition.

Solutions as exemplified herein (see Figure 4 by way of example) again refer to a high-side configuration, wherein the drain of an external MOSFET transistor such as M1 is connected to a battery S, while the source of the transistor M1 is connected to a load.

As noted, corresponding numerals and symbols in the different figures generally refer to corresponding parts unless otherwise indicated and a detailed description will not be repeated for each and every figure for brevity.

Figure 4 highlights again the fact that the load (to which an output voltage V_{OUT} is applied) can be per se a resistive load as exemplified by Rload, which however may be assumed to include a large capacitive component Cload (5-10 mF, for instance).

A solution as exemplified herein addresses the thermal instability problem discussed in the foregoing driving the gate of the (external) MOSFET transistor M1 with a variable gate-source voltage Vgs, so that the overdrive (Vgs-Vth), and therefore the current I_{OUT} supplied to the load Rload, Cload (drain current of the MOSFET transistor), is kept constant.

In fact, the current I_{OUT} can be calculated as follows: ${I}_{OUT} = {k}_{M 1} * {\left({V}_{gsM 1}-{V}_{thM 1}\right)}^{∧} 2$ wherein K_{M1} is a constant related to the physical structure of the external MOSFET transistor M1: therefore, if the overdrive V_{gsM1}- V_{thM1} is kept constant, there will be no increase of I_{OUT}.

In the formula above, V_{gsM1} denotes the gate-source voltage of the MOSFET transistor M1. It is otherwise noted that V_{thM1} is a lowest (minimum) threshold value among the MOS cells of the external MOSFET transistor M1 (see Figure 2).

The internal area of the MOSFET transistor M1 will be at a higher temperature with respect to the other areas. However, the reduction in Vth will not be followed by an increase of I_{OUT} provided, if Vth decreases, Vgs is likewise decreased, thus avoiding an increase of I_{OUT}. In other words, an increase of I_{OUT} automatically causes a decrease of Vgs, keeping the overdrive constant.

According to a first implementation as illustrated in Figure 4 the eFuse 10 includes an output node A. There a signal EXT_FET_G is produced to be applied via a drive node B to the control terminal (gate, in the case of a field-effect transistor such as the MOSFET transistor M1) via a RC low-pass circuit comprising a resistor R1 coupled between the node A and the node B and a capacitor C1 coupled between the node B and ground.

The RC circuit is not envisaged to be integrated in the eFuse 10 due to the size of its components.

The external MOSFET transistor M1 can thus be operated in saturation as a source follower. In other words, the output voltage V_{OUT} on the load Rload, Cload (the source of the MOSFET transistor M1) will follow the voltage level of the node B, namely, the voltage of the gate of the external MOSFET transistor M1.

The overdrive is kept constant if ${dV}_{B} / dt = {dV}_{OUT} / dt$

If the above equality is achieved and one considers that C1=Cload/k, then the current I_{C1} through the capacitor C1 is equal to ICload/k, thus making it possible to control the current flowing through Cload.

The structure illustrated in Figure 4 is based on an open loop topology, where Vgs is not constant.

In fact, Vgs is not constant since the MOSFET transistor M1 is connected to the node OUT coupled to the load, while the capacitor C1 is connected to ground GND. In other words, there is no dependence between I_{C1} and I_{Cload} (the current through the capacitor Cload). The voltage V_{OUT} increases as a function of the voltage level of the node B and not vice-versa. The structure illustrated in Figure 4 is an open-loop topology, where I_{Cload} is controlled by controlling dV_{B}/dt, that is the variation of the voltage at node B.

By way of further detail, the structure illustrated in Figure 4 comprises a gate driver circuit (GD) 100 arranged between a node CP coupled to the battery S (e.g., via a capacitor that is illustrated while not expressly labeled for simplicity).

As illustrated in Figure 4, the eFuse 10 includes two sensing nodes SENSE _P, SENSE_N that sense the voltage drop across the shunt resistor, and thus the current I_{OUT} supplied to the load Rload, Cload through the current flow path (source-drain, in the case of a field-effect transistor such as a MOSFET transistor) through the MOSFET transistor M1 to provide a sensing signal at a node Vs.

A possible structure for a gate driver circuit (GD) 100 is illustrated in Figure 4A.

Essentially, the gate driver circuit 100 comprises a first electronic switch 101 and a second electronic switch 102 (MOSFET transistors, for instance) arranged with the current flow paths therethrough (source-drain in the case of field-effect transistor such as MOSFET transistors) cascaded in a current flow line between the node CP and the output node OUT.

The node A from which the signal EXT_FET_G is derived is arranged at the current flow line between the node CP and the output node OUT in an intermediate position with respect the transistors 101 and 102.

A Zener diode 103 (e.g., with 20V Zener voltage) is arranged between the node A and the output node OUT. With the shown polarities, the Zener diode is arranged with its cathode and its anode towards the node A and the output node OUT, respectively.

In an arrangement as illustrated in Figures 4 and 4A, at power-up a voltage step is provided as an input to the eFuse causing the voltage EXT_FET_G (node A) to rise from 0V above V_{OUT} to 20V (the Zener voltage of the diode 103) above V_{OUT}.

This may occur in response to a drive signal being applied (in a manner known per se to those of skill in the art) to the drive terminals (gates in the case of field-effect transistor such as MOSFET transistors) of the transistors 101 and 102 via a control unit CU (a microcontroller, for instance) included, in a manner known per se to those of skill in the art, in the eFuse 10.

The (e.g., 20V) Zener diode 103 is configured to protect the control terminal (gate, in the case of a field-effect transistor such as a MOSFET transistor) of the external MOSFET transistor M1.

In fact, an external MOSFET transistor such as the MOSFET transistor M1 is configured to withstand a gate-source voltage Vgs of 20V maximum.

If, for example, the node CP is 14V above Vs (= 20V), considering V_{OUT}=0V (at power-up), without the (e.g., 20V) Zener diode 103, the gate-source voltage Vgs will be equal to 34V with the risk of damaging the MOSFET transistor M1.

Due to the presence of the 20V Zener diode, when the Vgs of the external MOSFET transistor M1 tends to increase above, e.g., 20V, the, e.g., 20V Zener diode 103 will clamp the gate voltage of the external MOSFET transistor M1 at, e.g., 20V above VOUT.

The signal EXT_FET_G will be at, e.g., 20V above V_{OUT} when the Zener diode 103 becomes conductive, namely when the voltage V_{OUT} reaches, e.g., 15V. In fact, as soon as the voltage V_{OUT} reaches, e.g., 15V, the voltage difference across the Zener diode will be CP (e.g., 34V) - 15V = 19V, namely the Zener diode 103 will be switched off. Following the switching off of the Zener diode 103 the signal EXT_FET_G will remain at CP.

In response to the step input provided at node A, the node B (the gate in the case of a field-effect transistor such as the MOSFET transistor M1) will try to reach the voltage at the node A with an exponential behavior determined by the network R1 and C1.

Figure 5 portrays a possible behavior of the voltages at node A (continuous line), node B (dashed line) and V_{OUT} (chain line) as discussed in the foregoing.

As soon as Vgs becomes greater than the threshold Vth (time t1), an overdrive is created and V_{OUT} starts increasing (during the interval t1-t2).

In case of hot spotting (during the interval t2-t3), namely in case the external MOSFET transistor M1 heats up, the current I_{OUT} increases. Therefore, the voltage V_{OUT} increases faster than the voltage at the node B (as discussed, the voltage V_{OUT} increases in response to more current flowing towards the node OUT).

If the voltage V_{OUT} increases, since the voltage at node B is independent of V_{OUT}, the voltage Vgs will decrease trying to switch the external MOSFET transistor M1 off (the source voltage of transistor M1 gets closer to its gate voltage).

The decrease of the voltage Vgs will cause a decrease in the overdrive and therefore the current I_{OUT} will decrease. If the current I_{OUT} decreases, the voltage V_{OUT} will decrease, given that there will be less current flowing towards the output node OUT, trying to keep the overdrive constant.

In case an additional load is added in parallel to the load Cload (during the interval t4-t5), there will be less current flowing in the load Cload, and the voltage V_{OUT} will remain almost constant or increases slower than before.

Therefore, considering that the voltage at node B increases independently of the voltage V_{OUT}, the voltage Vgs (and the overdrive) will increase.

In response to the increase in the overdrive, the current I_{OUT} will increase. Consequently, the voltage V_{OUT} will increase again, trying to keep the overdrive constant.

Figure 6 is again illustrative of a possible time behavior of the voltages at nodes A and B, the voltage V_{OUT} and the current I_{OUT}, which is kept essentially constant over time.

It is noted that the choice of the resistance/capacitance values for R1 and C1 depends on the desired dV_{B}/dt, that in the RC network comprised of R1 and C1 is given by the relationship: $Vc \left(t\right) = Vi * \left(1-{e}^{∧}\left(-t/τ\right)\right)$ where:
Vc(t) is the voltage across C1 at the time t,
Vi is the input voltage, and $τ = R 1 * C 1 .$

Figures 7 to 9 illustrate a second possible implementation of the solution proposed herein.

Here again, parts or elements already described in the foregoing (e.g., in connection with Figures 4 and 4A) are indicated with like reference symbols, and a corresponding description will not be repeated.

In the implementation of Figures 7 to 9, a signal generator 104 is integrated inside the eFuse 10 in order to produce a configurable dV_{gate}/dt behavior of a voltage V_{gate} at the node A in order to drive the control terminal (here, gate) of the MOSFET transistor M1 in a manner compliant with the relationship dV_{B}/dt = dV_{OUT}/dt discussed in the foregoing.

A possible implementation of the signal generator 104 (arranged between the node CP and ground GND, for instance) is illustrated in Figure 8.

There, a ramp generator 1041 is shown configured to receive an enable signal EN and to deliver an output reference voltage VREF to (the, e.g., non-inverting input of) a "high-voltage" operational amplifier 1042A.

The output from the operational amplifier 1042A provides an output signal towards the node A and is also coupled to a resistive voltage divider R1D, R2D between the output from the operational amplifier 1042A and ground.

The output of the divider (at an intermediate point between the resistors R1D and R2D) provides a scaled down replica of the output signal at node A as a feedback signal FB towards the (e.g., inverting input of) the operational amplifier 1042A.

The ramp generator 1041 produces a signal with a configurable behavior in terms of dV_{REF}/dt. A gain factor can be applied to that signal via the operational amplifier 1042A and the resistive divider R1D, R2D, the equivalent gain G being set as G = (R1D+R2D)/R2D.

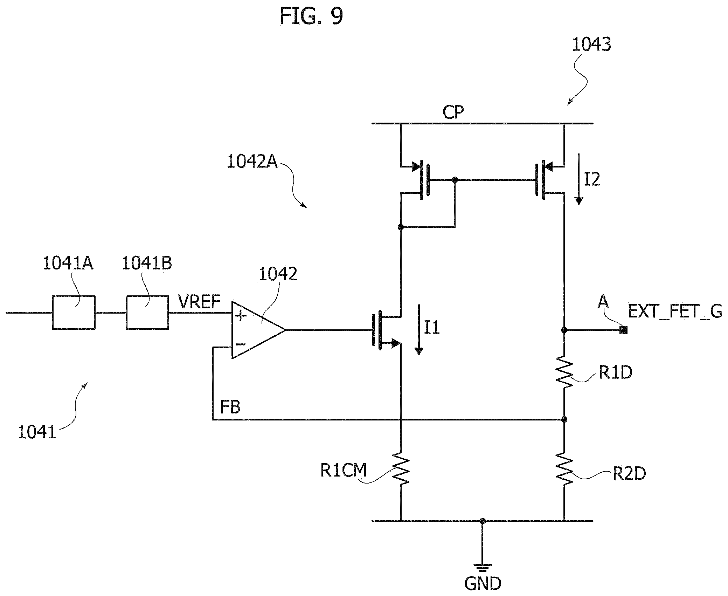

The high-voltage operational amplifier 1042A can be implemented, for instance, as exemplified in Figure 9, that is a combination of an operational amplifier 1042 and a level shifter 1043.

For instance (as illustrated in Figure 9), taking into account the charge pump supply, the supply of the operational amplifier 1042 may be referred to an internal low-voltage range with the output from the operational amplifier 1042 coupled to the node providing the signal at the node A via a level shifter including a current mirror arrangement, designated 1043 as a whole.

As illustrated, the current mirror arrangement 1043 is coupled between the node CP and ground GND and comprises:
a first branch (including a tail resistor R1CM) coupled to the output from the operational amplifier 1042 and through which a first current I1 flows, and
a second branch coupled to the node providing the signal HS_GATE through which a second current I2 flows that "mirrors" the first current I1.

Figure 9 also shows that the ramp generator 1041 can be implemented as a cascaded arrangement of a digital counter 1041A and a digital-to-analog converter 1041B.

The circuit 104 (ramp generator 1041, op-amp 1042, current mirror 1043) will drive the node where the signal HS_GATE is present (to be supplied to the control terminal, e.g., gate of the external MOSFET transistor M1) in such a way that the corresponding voltage level will increase from 0V towards the voltage at the node CP with a stepped shape.

Conversely, that voltage will increase slowly step-by- step in a predefined time interval Δt (e.g., a time interval nearly equal to 100ms).

The duration of Δt can be tuned so that, based on the capacitance value Cload (and that Cload is desired to be charged to reach battery level) the current I_{Cload} flowing through the capacitance Cload can be determined as follow: ${I}_{Cload} = Cload * \left(ΔV/Δt\right) ;$ wherein ΔV is the battery voltage level with respect to ground.

The voltage at node A will increase independently of V_{OUT} so that the gate-source voltage Vgs of the MOSFET transistor M1 can decrease/increase to keep the overdrive constant, just like in the first implementation discussed in connection with Figures 4 and 4A, that is with the same Vgs compensation.

In operation of the second implementation, illustrated in Figures 7 to 9, during the functioning of the circuit 104, the output from the gate driver circuit 100 is in a high impedance state, so that the circuit 104 can drive the control terminal (here, gate) of the external MOSFET transistor M1 without being hindered by the gate driver circuit 100.

Vice-versa, the output from the circuit 104 is in a high impedance state when the gate of the control terminal (here, gate) of the external MOSFET transistor M1 is desired to be increased/decreased quickly, e.g., when the capacitance Cload is already at battery level.

As soon as the circuit 104 is activated (via the enable signal EN), the digital counter 1041A starts to count with a certain frequency.

The counter frequency may be configurable by the user, e.g., via a dedicated RAM register, and plays a role in producing a dV_{gate}/dt time behavior as desired.

The DAC converter 1041B translates the digital counter output to an analog voltage level that acts as the input to the voltage level shifter 1042, 1043. This facilitates shifting the DAC output voltage to an acceptable voltage for the control terminal (here, gate) of the MOSFET transistor M1.

For instance, the gain of level shifter can be set to V_{HS_GATE_MAX}/V_{DAC_MAX}, where V_{HS_GATE_MAX}, and V_{DAC_MAX}, indicate the maximum (voltage) values for the signal HS_GATE and the DAC output.

After activation of the circuit 104, the described chain increases the voltage level of the control terminal (here, gate) of the external MOSFET transistor M1 from 0V towards the voltage level of the node CP with a stepped trend.

The external MOSFET transistor M1 operates as a source follower and, as soon as Vgs exceeds Vth, the voltage V_{OUT} applied to the load starts increasing with a stepped trend following the gate.

As discussed in connection with Figure 9, the level shifter 1042, 1043 can be implemented with an operational amplifier, a mirror supplied by a charge pump and a resistor ladder.

For instance, the non-inverting input of the operational amplifier 1042 can be handled by the DAC converter 1041B is such a way that, after a one-step increment, the non-inverting input of the operational amplifier is higher than the inverting input. The operational amplifier is unbalanced and increases its output, increasing the current I1 in turn increasing the voltage at node A, and, consequently, the non-inverting input of the operational amplifier.

The operational amplifier 1042 increases its output generating a higher current I1 through the resistor R1CM. The current I2 mirrors I1 and it is used to charge the input capacitance of the external MOSFET transistor M1 and to feed the resistor ladder (divider) R1D, R2D used to generate the feedback voltage FB for the inverting input of the operational amplifier 1042. The feedback voltage FB is increased and the inputs of the operational amplifier 1042 are balanced till the next step of digital counter.

The second implementation described in connection with Figures 7 to 9 comprises a monitoring feature of the load voltage V_{OUT}, namely a constant monitoring of the drain-source voltage of the MOSFET transistor M1: in response to this being lower than a threshold, the circuit 104 is turned off and set to a high impedance state.

Following the activation of the gate driver, the device will function essentially like the conventional eFuse device illustrated in Figure 1.

The second implementation described in connection with Figures 7 to 9 may likewise comprise diagnostic controls for possible failure of the circuit 104.

For instance, the device may constantly monitor the current through the external MOSFET transistor M1 by means of the shunt resistor Rshunt, and overcurrent (OVC) and HSC (hard short circuit: a current threshold for which the MOSFET transistor M1 is instantaneously turned off) thresholds may be configured during operation of the circuit 104 according to the accepted current.

For instance, the device may constantly monitor the voltage V_{OUT} applied to the load. If the voltage V_{OUT} is "stuck" to a voltage but the circuit 104 is found to try to increase the gate voltage, the continuous conduction mode (CCM) of operation of the circuit 104 is blocked.

The circuit 104 can in fact increase the voltage level of the control terminal (gate, in the case of a field-effect transistor) of the external MOSFET transistor M1 from 0V towards the voltage at the node CP and the 104 can possibly maintain the voltage of CP on that control terminal.

In certain situations, the circuit 104 can be switched off before the control terminal (gate, in the case of a field-effect transistor) of the external MOSFET transistor M1 reaches the voltage at CP and then the gate driver 100 will increase the voltage of that gate terminal to CP. The voltage level reached at that gate with the circuit 104 depends on the charging current of the capacitance Cload and on the gate-source voltage Vgs involved in that specific charging circuit.

For instance, if the current in the current flow path (source-drain, in the case of a field-effect transistor) of the external MOSFET transistor M1 is 10A, Vgs is 6.5V and Vth=3V, the circuit 104 will increase the voltage of the gate of M1 from 0V to 6.5V over battery level, in order to increase the voltage V_{OUT} to battery level, and the gate of the transistor M1 will not reach CP.

Then the gate driver 100 will suddenly increase towards the voltage of the node CP the voltage at the gate of the transistor M1 without incurring any thermal instability risk insofar as the voltage Vds is low (with the capacitance Cload completely charged).

The extent of protection is determined by the annexed claims.

## Claims

1. A circuit, comprising:
a capacitance (Cload) configured to be coupled to a source of electrical charge (S) via a drain-source current flow path through a field-effect transistor (M1),
drive circuitry (100, R1, C1; 100, 104) of the field-effect transistor (M1) configured to start charging the capacitance (Cload) by making the field-effect transistor (M1) selectively conductive in response to the gate-source voltage (Vgs) of the field-effect transistor (M1) exceeding a threshold (Vth), the difference between the gate-source voltage (Vgs) of the field-effect transistor (M1) and the threshold (Vth) providing an overdrive value of the field-effect transistor (M1),
wherein the drive circuitry (100, R1, C1; 100, 104) of the field-effect transistor (M1) is configured to drive the gate of the field-effect transistor (M1) with a variable gate-source voltage (Vgs) targeting a constant value for said overdrive value, wherein electrical charge is controllably transferred from the source (S) to the capacitance (Cload) via the drain-source current flow path of the field-effect transistor (M1),
wherein the drive circuitry (100, 104) comprises a ramp generator (1041) configured to apply to the gate of the field-effect transistor (M1) a controlled ramp signal (HS_GATE), and
the ramp generator (1041) comprises the cascaded arrangement of a digital counter (1041A) and a digital-to-analog converter (1041B).

2. The circuit of claim 1, wherein the drive circuitry (100, 104) comprises, cascaded to the ramp generator (1041), a level shifter circuit (1042, 1043) configured to apply to the gate of the field-effect transistor (M1) a level-shifted replica of the output (VREF) of the ramp generator (1041).

3. The circuit of claim 2, wherein the level shifter circuit (1042, 1043) comprises:
a gain stage (1042) coupled to the output (VREF) of the ramp generator (1041), and
a current mirror circuit (1043) coupled between the output of the gain stage (1042) and the gate of the field-effect transistor (M1).

4. A device, comprising:
a circuit according to any of claims 1 to 3,
an electrical load (Rload, Cload) comprising the capacitance (Cload) coupled to said source of electrical charge (S) via the drain-source current flow path of a field-effect transistor (M1), wherein the capacitance (Cload) in the electrical load (Rload, Cload) is configured to be charged in response to the gate-source voltage (Vgs) of the field-effect transistor (M1) exceeding a threshold (Vth).

5. The device of claim 4, wherein the device comprises an electronic fuse (10).

## Patentansprüche

1. Schaltung, umfassend:
eine Kapazität (Cload), die so ausgelegt ist, dass sie über einen Drain-Source-Strompfad durch einen Feldeffekttransistor (Ml) mit einer Quelle (S) der elektrischen Ladung gekoppelt ist,
einen Ansteuerschaltkreis (100, RI, Cl; 100, 104) des Feldeffekttransistors (Ml), der so ausgelegt ist, dass er das Laden der Kapazität (Cload) startet, indem der Feldeffekttransistor (Ml) selektiv leitfähig gemacht wird, als Reaktion darauf, dass die Gate-Source-Spannung (Vgs) des Feldeffekttransistors (Ml) einen Schwellenwert (Vth) überschreitet, wobei die Differenz zwischen der Gate-Source-Spannung (Vgs) des Feldeffekttransistors (Ml) und dem Schwellenwert (Vth) einen Übersteuerungswert des Feldeffekttransistors (Ml) bereitstellt,
wobei der Ansteuerschaltkreis (100, RI, Cl; 100, 104) des Feldeffekttransistors (Ml) so ausgelegt ist, dass er das Gate des Feldeffekttransistors (Ml) mit einer variablen Gate-Source-Spannung (Vgs) ansteuert, die auf einen konstanten Wert für den Übersteuerungswert abzielt, wobei elektrische Ladung steuerbar von der Quelle (S) zu der Kapazität (Cload) über den Drain-Source-Strompfad des Feldeffekttransistors (Ml) übertragen wird,
wobei der Ansteuerschaltkreis (100, 104) einen Rampengenerator (1041) umfasst, der so ausgelegt ist, dass er ein gesteuertes Rampensignal (HS_GATE) an das Gate des Feldeffekttransistors (Ml) anlegt, und
der Rampengenerator (1041) die kaskadierte Anordnung eines digitalen Zählers (1041A) und eines Digital-Analog-Wandlers (1041B) umfasst.

2. Schaltung nach Anspruch 1, wobei der Ansteuerschaltkreis (100, 104) eine an den Rampengenerator (1041) kaskadierte Pegelschieberschaltung (1042, 1043) umfasst, die so ausgelegt ist, dass sie an dem Gate des Feldeffekttransistors (Ml) eine pegelverschobene Replik des Ausgangs (VREF) des Rampengenerators (1041) anlegt.

3. Schaltung nach Anspruch 2, wobei die Pegelschieberschaltung (1042, 1043) umfasst:
eine Verstärkerstufe (1042), die mit dem Ausgang (VREF) des Rampengenerators (1041) gekoppelt ist, und
eine Stromspiegelschaltung (1043), die zwischen dem Ausgang der Verstärkerstufe (1042) und dem Gate des Feldeffekttransistors (Ml) gekoppelt ist.

4. Vorrichtung, die Folgendes umfasst:
eine Schaltung gemäß einem der Ansprüche 1 bis 3,
eine elektrische Last (Rload, Cload), die die Kapazität (Cload) umfasst, welche über den Drain-Source-Strompfad eines Feldeffekttransistors (Ml) mit der Quelle (S) der elektrischen Ladung gekoppelt ist, wobei die Kapazität (Cload) in der elektrischen Last (Rload, Cload) so ausgelegt ist, dass sie als Reaktion darauf geladen wird,
dass die Gate-Source-Spannung (Vgs) des Feldeffekttransistors (Ml) einen Schwellenwert (Vth) überschreitet.

5. Vorrichtung nach Anspruch 4, wobei die Vorrichtung eine elektronische Sicherung (10) umfasst.

## Revendications

1. Circuit, comprenant :
un condensateur (Cload) configuré pour être couplé à une source de charge électrique (S) par l'intermédiaire d'un chemin de circulation de courant drain-source à travers un transistor à effet de champ (M1),
une circuiterie d'attaque (100, R1, C1 ; 100, 104) du transistor à effet de champ (M1) configurée pour commencer à charger le condensateur (Cload) en rendant le transistor à effet de champ (M1) sélectivement conducteur en réponse au fait que la tension grille-source (Vgs) du transistor à effet de champ (M1) dépasse un seuil (Vth), la différence entre la tension grille-source (Vgs) du transistor à effet de champ (M1) et le seuil (Vth) donnant une valeur d'attaque excessive (*overdrive*) du transistor à effet de champ (M1),
dans lequel la circuiterie d'attaque (100, R1, C1 ; 100, 104) du transistor à effet de champ (M1) est configurée pour attaquer la grille du transistor à effet de champ (M1) avec une tension grille-source (Vgs) variable ciblant une valeur constante pour ladite valeur d'attaque excessive, une charge électrique étant transférée de manière commandable de la source (S) au condensateur (Cload) par l'intermédiaire du chemin de circulation de courant drain-source du transistor à effet de champ (M1),
dans lequel la circuiterie d'attaque (100, 104) comprend un générateur de rampe (1041) configuré pour appliquer à la grille du transistor à effet de champ (M1) un signal en rampe commandé (HS_GATE), et
le générateur de rampe (1041) comprend le montage en cascade d'un compteur numérique (1041A) et d'un convertisseur numérique-analogique (1041B).

2. Circuit selon la revendication 1, dans lequel la circuiterie d'attaque (100, 104) comprend, connecté en cascade au générateur de rampe (1041), un circuit de décalage de niveau (1042, 1043) configuré pour appliquer à la grille du transistor à effet de champ (M1) une version à niveau décalé de la sortie (VREF) du générateur de rampe (1041).

3. Circuit selon la revendication 2, dans lequel le circuit de décalage de niveau (1042, 1043) comprend :
un étage de gain (1042) couplé à la sortie (VREF) du générateur de rampe (1041), et
un circuit miroir de courant (1043) couplé entre la sortie de l'étage de gain (1042) et la grille du transistor à effet de champ (M1).

4. Dispositif, comprenant :
un circuit selon n'importe laquelle des revendications 1 à 3,
une charge électrique (Rload, Cload) comprenant le condensateur (Cload) couplé à ladite source de charge électrique (S) par l'intermédiaire du chemin de circulation de courant drain-source d'un transistor à effet de champ (M1), le condensateur (Cload) de la charge électrique (Rload, Cload) étant configuré pour être chargé en réponse au fait que la tension grille-source (Vgs) du transistor à effet de champ (M1) dépasse un seuil (Vth).

5. Dispositif selon la revendication 4, le dispositif comprenant un fusible électronique (10).
